# EUROPEAN PATENT APPLICATION

(11) **EP 2 782 255 A1**
(43) Date of publication of application: **24.09.2014**
(21) Application number: 13159908.6
(22) Date of filing: 19.03.2013
(51) Int. Cl.: H03L 7/16

(54) **Fractional-N frequency synthesizer using a subsampling pll and method for calibrating the same**

(71) Applicant: IMEC, 3001 Leuven (BE)
(72) Inventor: Craninckx, Jan, 3001 Leuven (BE); Raczkowski, Jakub, 3001 Leuven (BE)
(74) Representative: Van Bladel, Marc

(57) **Abstract**

The present invention relates to a circuit (10) for implementing fractional-N frequency synthesis comprising a phase-locked loop (1) arranged for receiving a reference signal (2), for performing sampling phase detection (3) on a signal derived from the reference signal (2) and for generating an output signal (7) at a frequency derived from the reference signal. The circuit comprises generator means (5) for generating the reference signal for the phase-locked loop by adding an amount of delay to a clock signal (6) received by the generator means, said amount of delay being different from an integer number of periods of the clock signal.

## Description

### Field of the invention

The present invention is generally related to the field of fractional-N frequency synthesizers used in digital communication systems. More precisely, it relates to a frequency synthesizer based on a subsampling Phase-Locked Loop (PLL).

### Background of the invention

Many PLL architectures are known in the art. The most widely-used traditional PLL architecture contains a frequency divider divide-by-N, a phase-detector(PD)/charge-pump(CP), a loop filter (LF) and a voltage controlled oscillator (VCO). In such a conventional PLL the main loop noise sources are usually the PD/CP and the divider. Due to the presence of the divide-by-N in the feedback path, the PD/CP and divider noise (in power) is multiplied by N² when transferred to the PLL output.

By applying a sampling or sample-and-hold phase detection (PD) the use of a frequency divider can be avoided. Hence, divider noise and power dissipation can be eliminated. However, using a sampling PD has drawbacks like the need for a large filter capacitor (due to its large detection gain) and limited acquisition range, which have kept it from wide use in fully integrated PLLs.

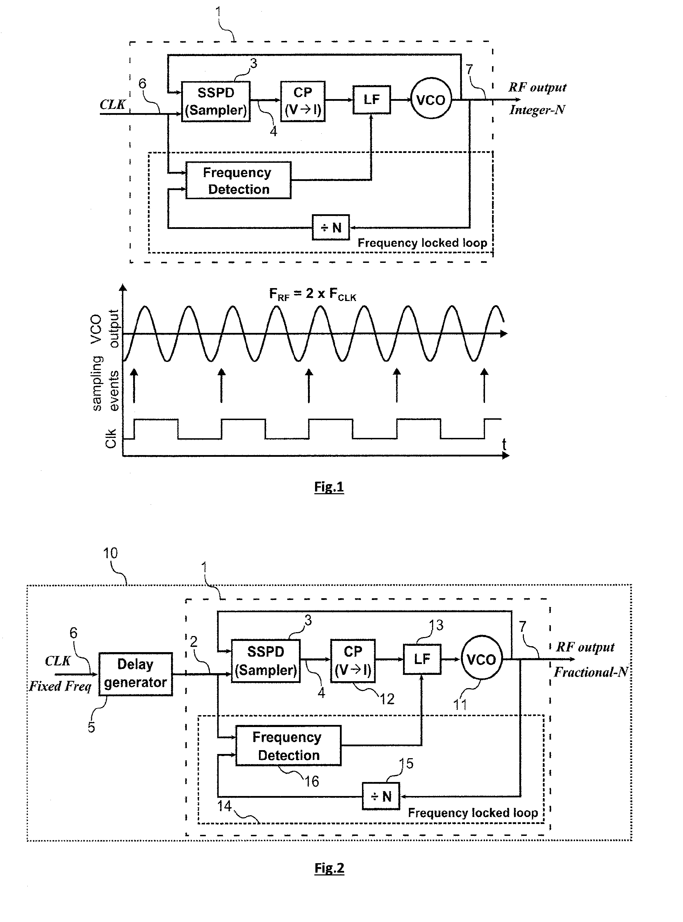

In the paper 'A Low Noise Sub-Sampling PLL in Which Divider Noise is Eliminated and PD/CP Noise is Not Multiplied by N2' (X.Gao et al., Proc. IEEE JSSCC, Vol. 44, No. 12, December, 2009) a (sub-)sampling PLL architecture is presented that overcomes these drawbacks. In contrast to a traditional PLL, there is no frequency divider in the loop in the proposed scheme and the phase detector (PD) operates directly on the VCO phase instead of on the phase of the divided signal. A block scheme of this PLL architecture utilizing the sub-sampling phase detection/charge pump (SSPD/CP), which is referred to as subsampling PLL (SSPLL), is shown in Fig.1.

The SSPLL system operates by directly sampling the differential sinusoidal output of the VCO (Fig.1). This sampling is performed at a rate corresponding to a reference source *Ref* (e.g. 40MHz), which is much lower than the high frequency VCO signal. Therefore in fact sub-sampling is applied. The sampled differential voltage is converted by a transconductor into a current (*CP*), which is fed into the (current driven) low-pass loop filter (LF) generating a corrective update at the VCO input. In locked state the zero crossing of the differential wave is sampled. This results in a zero current update and zero update to VCO control voltage (vₜᵤₙₑ). Due to the absence of the frequency divider and the very high phase detector gain, noise originating from the succeeding components (CP and LPF) is suppressed, and hence the synthesizer phase noise is very low.

However, the subsampling operation is only reasonable if the VCO runs at a frequency which is an integer multiple of the sampling clock (so that it can synthesize frequencies which are integer multiples of the reference frequency (e.g. 40MHz)). Only then the sampling "hits" the zero crossings of the VCO output accurately. Therefore, the loop is inherently forced to work in integer-N mode. For most of modern wireless standards this limitation is crucial and unacceptable.

Solutions for fractional-N frequency synthesis have been proposed in the literature. In the paper 'A Design Methodology to Enable Sampling PLLs to Synthesise Fractional-N Frequencies' (Tao Xu et al., IEEE European Conference on Circuit Theory and Design (ECCTD) 2011, pp.353-356) a sampling phase-locked loop is presented that combines the advantages of both conventional fractional-N PLL and SPLL, such as a faster frequency switching, a smaller phase jump and a larger loop gain. Since, as already mentioned, the frequency divider can be omitted in SPLL, the associated phase noise, power and hardware consumption can be ignored. Fractional-N frequencies are generated with the classic method of interpolating the multiphase VCO output. However, the multiphase VCO is very difficult to implement by itself and the number of generated phases is inevitably limited to a few phases, increasing quantization noise. Moreover, for a VCO operating at RF frequencies, either multiphase VCO or an additional phase interpolator together with the phase selector bring an important increase both in power consumption and phase noise.

Another approach for converting an integer-N PLL to a fractional-N one is given in the paper 'A 2.9-4.0-GHz Fractional-N Digital PLL With Bang-Bang Phase Detector and 560-fsrmc Integrated Jitter at 4.5-mW Power' (D. Tasca et al., IEEE Journal of Solid-State Circuits, vol. 46, no 12, December 2011, pp.2745-2758). The system adds a 'fractional frequency divider' to the classical loop of a digital bang-bang PLL, enabling fractional-N operation in an inherently integer-N loop. The concept of the fractional frequency divider involves a controllable delay element which modulates the phase of the divided signal according to the necessary fractional-N division factor. However, this solution is not applicable to a subsampling PLL, because the SSPLL does not implement a divider in the loop (except for frequency acquisition mode) and therefore the 'fractional divider' would need to operate on the high frequency VCO signal, what in practice would be very difficult to accomplish.

In patent document US7737743 a phase-locked loop is disclosed including sampling comprising a sample phase detector and charge pump with pulse width modulation. The document's content corresponds to the above-mentioned paper by Gao et al.

Hence, there is a need for a solution where fractional-N frequency synthesis is performed in an efficient way.

### Summary of the invention

It is an object of embodiments of the present invention to provide for a circuit that allows any phase-locked loop circuit to operate as a fractional-N frequency synthesizer. It is a further object of the invention to provide an appropriate method to calibrate such a fractional-N frequency synthesis circuit.

The above objective is accomplished by the solution according to the present invention.

In a first aspect the invention relates to a circuit for implementing fractional-N frequency synthesis comprising a phase-locked loop arranged for receiving a reference signal, for performing sampling phase detection on a signal derived from the reference signal and for generating an output signal at a frequency derived from that reference signal, **characterised in that** the circuit comprises generator means for generating the reference signal for the phase-locked loop by adding an amount of delay to a clock signal received by the generator means, said amount of delay being different from an integer number of periods of the clock signal.

The circuit indeed meets the objectives. Due to the delay generation an amount of delay equal to a fraction of a clock period can be added so that the clock signal phase is modified and at the output of the phase-locked loop a signal is obtained at a frequency that is a fractional multiplication of the clock frequency.

In a preferred embodiment the phase-locked loop is an integer-N phase-locked loop.

In an advantageous embodiment the amount of delay is variable.

Advantageously, the generator means comprises a delay block arranged for adding the amount of delay to the clock signal.

In another embodiment the circuit comprises control means for controlling the delay block. Preferably the control means is arranged for calculating the amount of delay.

In a specific embodiment the delay block is a digital-to-time converter.

In a preferred embodiment said control means is operable based on delta-sigma modulation.

In a second aspect the invention also relates to method for calibrating a circuit for implementing fractional-N frequency synthesis as previously described, comprising the steps of
- determining an error between a signal representative of a phase error in the phase-locked loop and a signal related to the amount of delay,
- adjusting the amount of delay added to the clock signal, taking into account the error.

In a preferred embodiment said signal representative of the phase error is a signal output by phase detection means in the phase-locked loop.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

### Brief description of the drawings

The invention will now be described further, by way of example, with reference to the accompanying drawings, wherein like reference numerals refer to like elements in the various figures.

Fig.1 illustrates a conventional subsampling PLL (SSPLL) and its operation.

Fig.2 illustrates a circuit for implementing fractional-N frequency synthesis according to the invention.

Fig.3 illustrates the operational principle of the proposed solution.

Fig.4 illustrates an embodiment of the present invention.

Fig.5 illustrates a possible design for circuit for calibrating the fractional-N frequency synthesis circuit.

Fig.6 represents some calibration results.

Fig.7 illustrates a scheme of the full system.

Fig.8 illustrates an example of analysis of the influence of DTC gain error on the PLL.

### Detailed description of illustrative embodiments

The present invention will be described with respect to particular embodiments and with reference to certain drawings but the invention is not limited thereto but only by the claims.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

It should be noted that the use of particular terminology when describing certain features or aspects of the invention should not be taken to imply that the terminology is being redefined herein to be restricted to include any specific characteristics of the features or aspects of the invention with which that terminology is associated.

In the description provided herein, numerous specific details are set forth. However, it is understood that embodiments of the invention may be practiced without these specific details. In other instances, well-known methods, structures and techniques have not been shown in detail in order not to obscure an understanding of this description.

The present invention proposes a fractional-N frequency synthesis circuit wherein a variable delay generator is introduced in the path of the reference signal applied to the subsampling PLL. The scheme of Fig. 2 shows the proposed modification to the system of integer-N subsampling PLL.

In the scheme of Fig.2 sampling is still performed at a much lower rate than the VCO (11) frequency. A transconductor 12 converts the sampled voltage into a current, which is applied to a low-pass loop filter (LF) 13. The delay generator block 5 modifies the clock signal phase in such way that the subsampling PLL 1 generates at its output a signal 7 at a frequency being a fractional multiplication of the clock frequency 6. A sampler 3 is used as a detector of phase difference between the RF output and the reference generated by the delay generator. As this type of phase detector has no frequency tracking capability, a frequency locked loop 14 operates as an auxiliary control loop. It comprises a classical frequency divider chain 15 and a conventional phase-frequency detector (PFD) 16 which has been enhanced by increasing its dead-zone.

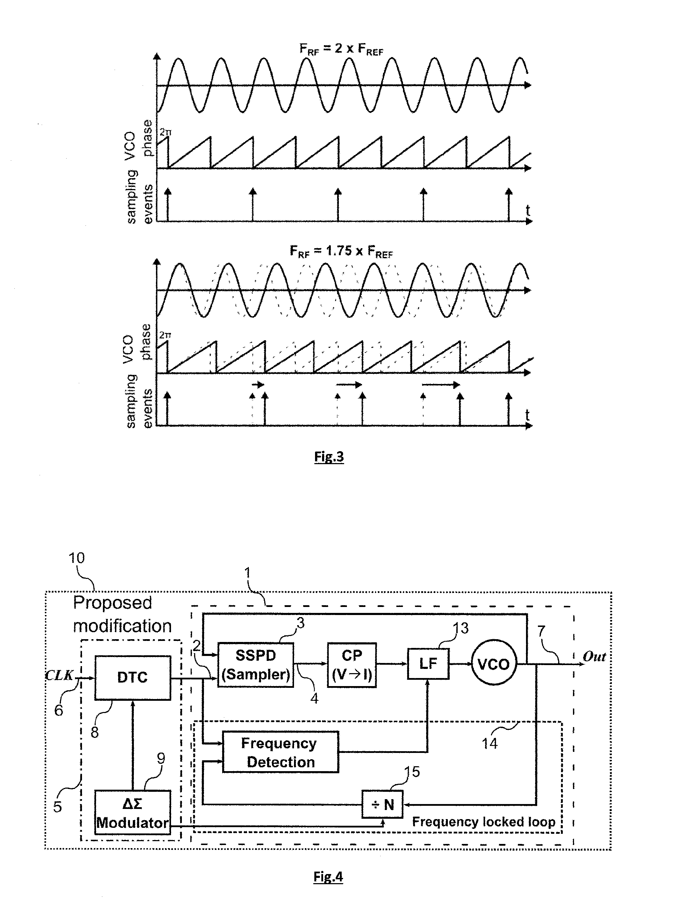

To enable fractional operation of the synthesizer one still operates in this invention by sampling the VCO phase with the reference. However, the instantaneous sampling phase is changed by a fraction such that it will sample at the desired zero crossings of the VCO signal running at a non-integer (fractional) frequency. This is illustrated in Fig.3. At the top of Fig.3 are shown the sampling events and VCO phases in case of a conventional integer-N scheme (similar to the one shown in Fig.1). The figure at the bottom illustrates the approach with delay generation adopted in this invention.

The instantaneous phase is generated by changing consecutive periods of the clock signal. One way to implement a variable delay is to use a digital-to-time converter (DTC) and applying different delays to the consecutive clock edges, thereby creating a reference signal. Once this reference signal is phase modulated, the whole SSPLL 1 closely follows this reference phase and after multiplication in the loop one obtains a fractional-N sub-sampling system as shown in Fig.4. The digital codes driving the DTC are representing the targeted phase of the output and are generated based on a Delta-Sigma modulator 9. Though the modulator is not strictly required for phase computations, it simplifies the process since the average of its output moved to the phase domain represents directly the target phase of the PLL. Moreover, the output of the modulator can be used directly to drive the divider 15 of the frequency-locked loop 14. This way the frequency-locked loop also operates in fractional-N mode. It is important to note that also in this case the frequency-locked loop is inactive - it does not create any signal driving the low-pass filter 13. It is only used for initial frequency acquisition and for tracking possible phase-unlock events. Therefore, though inactive, it has to follow the frequency and phase of the subsampling loop and operate in fractional-N mode.

Advantageously, the modification to the subsampling PLL is done outside the main phased locked loop, as in Fig.4. Therefore, the performance and operation of the subsampling loop is not modified and can achieve very low phase noise. Moreover, thanks to operation at the clock frequency (which is relatively low) the power consumption of the DTC can be low. Finally, the required range of the DTC corresponds to the VCO period and is therefore small and realizable.

The subsampling operation is not aware of the frequency ratio between the VCO and the reference clock. In other words, this PLL control loop only has phase-locking capability without frequency awareness. This can be intuitively understood, as the principle of the subsampling mode involves targeting a "hit" of a zero-crossing of the wave generated by the VCO (see sampling events in the bottom figure in Fig.3). These "hits" occur only once per reference period, without any control of the number of VCO cycles in between the periods. The same output is generated for (N) and for (N+1) integer ratios. Therefore, another loop is required around the VCO to set the correct working frequency. This additional loop 14 works as a frequency-locked loop (FLL) only (see the schemes in Fig.1, 2 and 4). Once the correct frequency is acquired, this loop becomes inactive, as phase control (via the sampling loop) is sufficient to maintain the system in locked state. Once the relation between the clock and the VCO output is distorted (as in a sudden phase unlock event), the FLL takes over priority to regain the frequency lock and again allow phase locking.

For example, if the required fractional frequency multiplication is (for instance) 249.6 (x40MHz=9.976GHz) but the integer-N loop can only generate either 249 (9.96GHz) or 250 (10GHz) a Delta-Sigma (DS) modulator can be used, which gives a sequence of numbers consisting only of (249, 250) but which average value is precisely 249.6. Traditional PLLs comprising a frequency divider in the phase-tracking loop use this data stream of the Delta-Sigma modulator to synthesize output signal that has a fractional-N relation to the CLK signal. However, in the case of a sub-sampling PLL where, as already mentioned, the frequency divider is present only in the frequency acquisition loop and is disabled during normal phase-tracking operation, this approach cannot be applied. In the proposed solution, however, this data stream is used to calculate the delay that has to be generated by the DTC in order to modulate the reference clock period and to achieve fractional-N subsampling operation. The error of the Delta-Sigma stream (i.e. the difference between required fractional number and the instantaneous integer number) is simply the fraction of the VCO period by which the reference clock has to be delayed. This error can be accumulated and converted to the phase domain to allow tracking of the PLL target phase. As the loop is autonomous, the generated fractions need to be accumulated in order to "follow" the loop phase with generation of codes for the DTC. Once the generated delay surpasses one VCO period, the delay generation can wrap to zero thanks to the periodic response of the subsampling phase detector. This means that after tracking the zero crossings of one VCO cycle during one VCO period, one can skip to track a neighbouring VCO cycle. As an example, in Fig. 3 the fractional frequency of 1.75 is realized, which means that after four reference cycles one VCO cycle can be skipped and delay generation starts again from zero.

The fractional-N subsampling PLL as shown in Fig.4 depends on a Digital-to-Time converter (DTC) circuit 8, which is a generic digital-to-analogue converter and as such can be implemented in numerous ways. This is needed to modulate the clock period to enable the fractional-N operation. However, the gain of the DTC (digital code → delay) is unknown or uncertain and requires calibration. If the DTC fails to provide correct gain, spurious tones are generated in the synthesizer output spectrum, lowering the quality of the generated signal. Therefore, a method of on-line, on-chip calibration of the DTC gain is necessary to obtain proper operation of the fractional-N subsampling PLL.

More specifically, the calibration makes sure that the delay step generated by the delay generator block (e.g. DTC) fits with the delay assumed during system modelling and simulations. If this is not the case, the loop will still lock to a correct frequency. However, it will produce many more spurious effects and the signal quality (phase noise) will be worse.

By observing the vₛₐₘ voltage 4 (a result of sampling the VCO output), which gives a measure of the phase error, and comparing its sign with the change of Delta-Sigma (DS) stream 19 one can find out whether the DTC gain is lower or higher than expected. This yields a "bang-bang" control mechanism, which can then be used to tune (calibrate) the DTC gain.

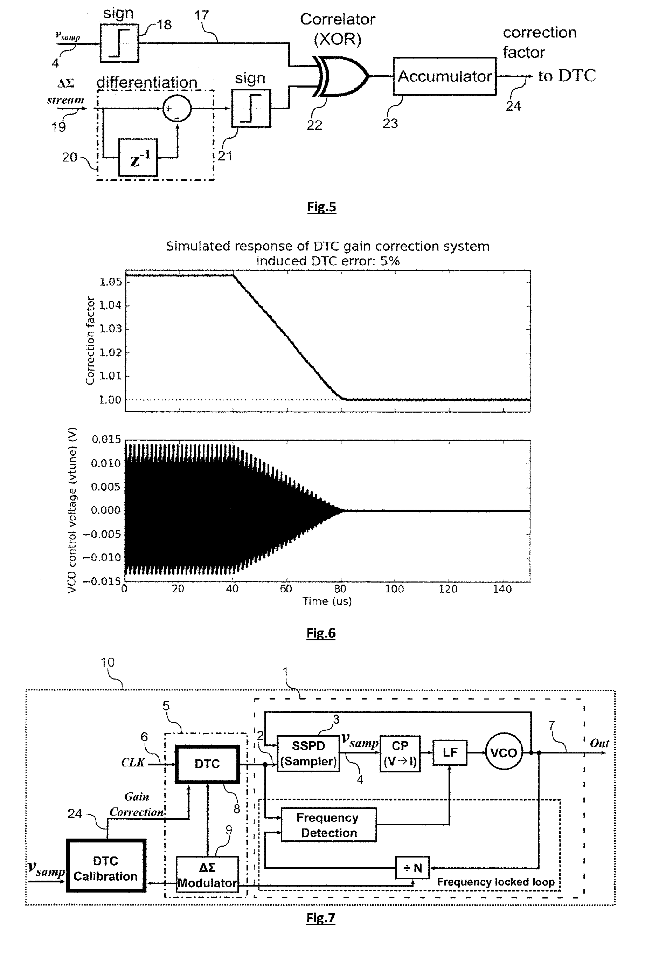

By correlating the single-bit streams of the change of the generated delay 19 and the resulting sign of the Vₛₐₘ voltage (which is accomplished by a simple XOR gate) the erroneous loop behaviour due to the DTC gain mismatch can be detected. By accumulating the error signal a correction factor 24 can be produced to be multiplied with the DTC digital code. Thanks to that, the loop self-regulates towards zero gain error. An example circuit that realizes the above-mentioned functionality is shown in Fig. 5.

Fig. 5 shows an example realization of the correction mechanism. The sampling phase detector output vₛₐₘₚ 4 carries the information about the gain error. This signal is converted into a single-bit digital signal 17 by means of a comparator 18. On the other hand, the delta-sigma modulator output 19 carries the information about the targeted phase changes. Therefore, a differentiator 20 and a sign operator 21 are used to extract this information. Afterwards, a correlating stage is used, which in case of single-bit information can be implemented as a simple XOR gate 22. The correlator output is in the form of a single-bit stream that has to be accumulated 23 to obtain a DTC error estimation. This correction factor 24 can be fed to the DTC in order to adjust its gain.

A sample of simulation results of the correction loop is shown in Fig.6. The error imposed on the DTC was set to +5%. After a prefixed time (e.g. 10 µs) the correction loop brings the DTC correction value to within 0.1% of ideal DTC gain (top figure). At this time the algorithm oscillates slowly around the optimal value, with the oscillation amplitude dependent on the minimal step of the correction factor. The sampled voltage (i.e. Vₛₐₘ after the 80 µs) shown in the bottom figure is indeed much smoother in the calibrated case, assuring minimization of the spurs coming from the DTC.

A system diagram of the fractional-N subsampling PLL with DTC gain calibration is shown in Fig.7. The calibration block takes as input the Delta-Sigma stream 19 and the vₛₐₘ voltage 4 and outputs the DTC gain correction coefficient 24.

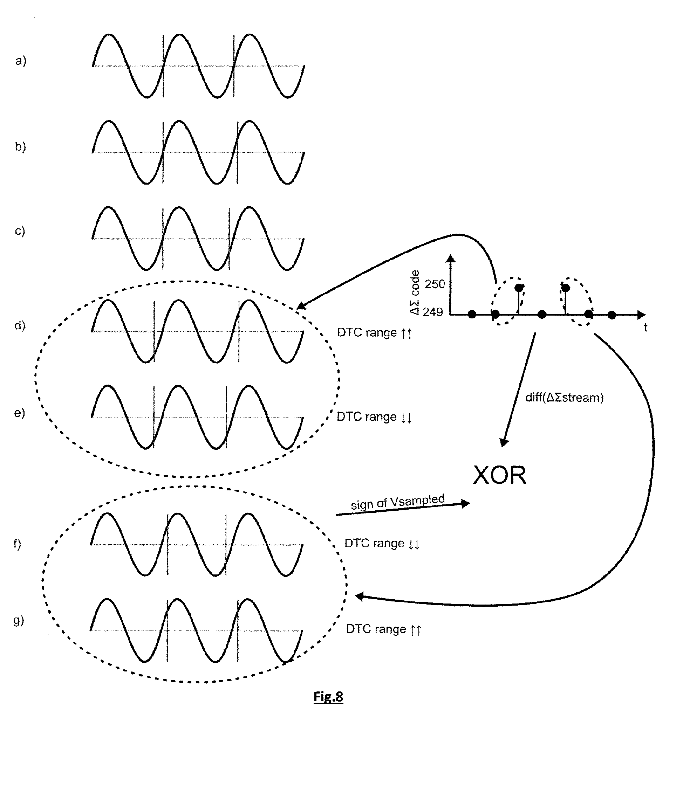

The examples shown in Fig.8 are now considered. In case a) the ideal operation is shown, where the sampler hits perfectly coincide with zero crossings of the VCO wave. In case b) the first hit is at the zero crossing, whereas the second hits later. This may occur due to two possible reasons: either when the DTC gain is too high or when the DS modulator actually wants to force the PLL to slow down (increase its period). In case c) the opposite occurs : the first hit is on a zero crossing, but the second is "early". This either means that the DTC gain is too low or that the DS asks the PLL to speed up (shorter period). Importantly, if it is the DS modulator that causes these "hits", the DTC gain is (potentially) correct and should not be altered.

In cases d) to g) the effects are more pronounced, the first hit comes either early (d-e) or late (f-g) and the second one either late (d-g) or early (e-f). From cases b) and c) it is already known the DS modulator can cause a "missed" hit even with an ideal DTC. This is because the modulator has a fixed resolution. By observing the derivative of the DS code one knows when a DS code change happened. This change in code tells the PLL either "slow-down" or "speed-up". If the PLL should speed up, the VCO wave should be sampled earlier than the zero crossing (and consequently reduce the period). However, if in this case (DS tells "speed-up") sampling is performed after the zero crossing, and hence one knows the DTC gain is too large. In the opposite case, when the DS modulator tells the PLL to slow down (should hit after zero crossing) but one samples before the zero crossing, it is sure it is the DTC gain which is too large. This way, a "bang-bang" calibration method can be implemented which tries to reduce or increase the gain of the DTC, based on the differential of the DS code and the sign of the sampled VCO wave voltage. This algorithm will then approach the optimal value and oscillate (jump around the optimum), at that time it may be disabled or left operating to correct for environment changes.

While the invention has been illustrated and described in detail in the drawings and foregoing description, such illustration and description are to be considered illustrative or exemplary and not restrictive. The foregoing description details certain embodiments of the invention. It will be appreciated, however, that no matter how detailed the foregoing appears in text, the invention may be practiced in many ways. The invention is not limited to the disclosed embodiments.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

## Claims

1. Circuit (10) for implementing fractional-N frequency synthesis comprising a phase-locked loop (1) arranged for receiving a reference signal (2), for performing sampling phase detection (3) on a signal derived from said reference signal (2) and for generating an output signal (7) at a frequency derived from said reference signal, **characterised in that** the circuit comprises generator means (5) for generating said reference signal for said phase-locked loop by adding an amount of delay to a clock signal (6) received by said generator means, said amount of delay being different from an integer number of periods of said clock signal.

2. Circuit for implementing fractional-N frequency synthesis as in claim 1, wherein said phase-locked loop is an integer-N phase-locked loop.

3. Circuit for implementing fractional-N frequency synthesis as in claims 1 or 2, wherein said amount of delay is variable.

4. Circuit for implementing fractional-N frequency synthesis as in any of the previous claims, wherein said generator means comprises a delay block (8) arranged for adding said amount of delay to said clock signal.

5. Circuit for implementing fractional-N frequency synthesis as in claim 4, comprising control means (9) for controlling said delay block.

6. Circuit for implementing fractional-N frequency synthesis as in claim 5, wherein said control means is arranged for calculating said amount of delay.

7. Circuit for implementing fractional-N frequency synthesis as in any of claims 4 to 7, wherein said delay block is a digital-to-time converter.

8. Circuit for implementing fractional-N frequency synthesis as in claim 5, wherein said control means is operable based on delta-sigma modulation.

9. Method for calibrating a circuit for implementing fractional-N frequency synthesis as in any claim 1 to 8, comprising the steps of
- determining an error between a signal representative of a phase error in said phase-locked loop and a signal related to said amount of delay,
- adjusting said amount of delay added to said clock signal, taking into account said error.

10. Method for calibrating as in claim 9, wherein said signal representative of said phase error is a signal (4) output by phase detection means in said phase-locked loop.
